# EUROPEAN PATENT APPLICATION

(11) **EP 3 471 144 A1**
(43) Date of publication of application: **17.04.2019**
(21) Application number: 17196068.5
(22) Date of filing: 12.10.2017
(51) Int. Cl.: H01L 27/11, H01L 21/8234, H01L 21/8238, H01L 27/12, H01L 29/417, H01L 29/66, H01L 29/78

(54) **SEMICONDUCTOR FIN STRUCTURE WITH VARYING HEIGHT**

(71) Applicant: IMEC vzw, 3001 Leuven (BE)
(72) Inventor: RAGHAVAN, Praveen, 3001 Leuven (BE); WECKX, Pieter, 3001 Leuven (BE); SHERAZI, Syed Muhammad Yasser, 3001 Leuven (BE); KIM, Ryan Ryoung han, 3001 Leuven (BE)
(74) Representative: AWA Sweden AB

(57) **Abstract**

A semiconductor structure (10) is disclosed, comprising a substrate (100), at least one fin-shaped feature (110), and an isolating feature (150). The at least one fin-shaped feature is arranged on the substrate, having a length in a direction extending along the substrate and a height in a direction extending from a surface of the substrate. The fin-shaped feature has a first portion (111) which protrudes with a first height (T) from the isolating feature which is arranged on the substrate, and a second portion (H₂) which protrudes with a second height (S) from the isolating feature. An SRAM cell (20) comprising such a structure, and an associated manufacturing method are also disclosed.

## Description

### Technical field

The present inventive concept relates semiconductor devices having fin-shaped structures, and to the manufacturing of such devices.

### Background

There is a continuous need for down-scaling of integrated circuits and demanding requirements for higher speed. Owing to this strive, transistors need to have higher drive currents with increasingly smaller dimensions.

In one attempt to address these needs, fin field-effect transistors (FinFETs) were developed. FinFETs have increased channel width because the channels include sidewall portions in addition to the portion on the top surfaces of the fins. Since the drive currents of transistors are proportional to the channel widths, the drive currents of FinFETs are increased over those of planar transistors.

Even though the FinFET technology provides advantages over the planar technology, there is still a need for a technology enabling improved control of the fin based transistors and allowing for further down-scaling of the integrated circuits.

### Summary

An objective of the present inventive concept is to provide a technology allowing for transistor devices having improved performance. Additional and alternative objects may be understood from the following.

According to a first aspect of the present inventive concept, there is provided a semiconductor structure comprising a substrate, at least one fin-shaped feature arranged on the substrate, and an isolating feature. The fin-shaped feature has a length in a direction extending along the substrate and a height in a direction extending from a surface of the substrate. A first portion of the fin-shaped feature protrudes with a first height from the isolating feature, whereas a second portion of the fin-shaped feature protrudes with a second height from the isolating feature.

The fin-shaped feature, generally referred to as "fin", may have a top surface and two opposing sidewalls that protrude from the isolating feature. The fin may e.g. be formed by etching trenches in the substrate and filling the trenches with an oxide. Transistor devices, such as e.g. FinFETs, may then be formed by providing a gate stack overlying the protruding portions of the fin. Thus, since the gate stack may be arranged at three surfaces of the fin, i.e., the protruding portion, three channel portions or gate portions may be formed. The height of the two sidewalls and the width of the top surface may add up to a total gate width or channel width, to which the drive current of the transistor may be proportional. Thus, increasing the width (or area) may result in an increase in drive current and in an improved (decreased) Vccₘᵢₙ (minimum power supply voltage required to operate a device).

Generally, the gate width may be increased by increasing the height of the fin rather than increasing the width of the fin, since the latter may result in an increased footprint of the resulting integrated circuit. However, increasing the transistor fin height may also result in an increased gate capacitance, which may result in a degradation of dynamic capacitance.

The present inventive concept allows for transistors of different channel width to be formed on the same fin. Hence, transistors that have different drive currents can be combined along the same fin. This is of particular interest in applications having both p-type transistors and n-type transistors, such as e.g. inverters, wherein a greater channel width of p-type transistors may compensate for the lower hole mobility compared to the higher electron mobility of n-type transistors. Thus, the performance of a p-type transistor and the performance of an n-type transistor may be balanced by the channel width.

Further, the inventive concept allows for the transistor channel width (or channel height) to be individually adjusted or optimized according to the specific requirements put on each transistor. In this way, the channel width can be selectively increased for some transistors without having to increase the height of the entire (or all) fin(s). This is advantageous, since an increased fin height may lead to undesired increase in cell capacitance.

The present inventive concept also allows for transistors of different channel width to be manufactured in a process in which several or all of the fins are formed with the same height. Such a process may be easier and simpler compared to processes utilizing fins of different heights. Thus, a set of uniform fins may be formed by e.g. etching and filling trenches defining the extension of the fins, wherein the height of the respective protruding portions may be defined by adjusting the height of the surrounding isolation.

The substrate may e.g. be a bulk silicon substrate or silicon-on-insulator substrate supporting the fin-shaped features, which may be formed in the substrate, by etching trenches that are filled with e.g. an oxide, and/or provided on the substrate by e.g. a selective deposition of material, such as e.g. epitaxial growth.

The isolating feature may be understood as a structure arranged at, or partly covering, the sides of a fin. The isolating feature may provide isolation between neighbouring fins and also isolate parts of the fin from the gate stack. Thus, the isolating feature may be arranged such that only a portion of the fin protrudes from the isolating feature, allowing the protruding portion to be contacted by the gate stack and hence define a channel region of a transistor device. The isolating feature may e.g. be understood as one or several trench isolations, such as STIs, extending along the fin. When used in the context of the present application, the term "isolating feature" may refer to a specific isolating structure at a specific transistor location of a fin, or to a plurality of isolating structures defining several different channel regions. The isolating feature may for an example be made from or comprise SiO₂, SiN, SiON, or SiOCN, or combinations thereof

As already mentioned, the fin-shaped features may be referred to as "fins". They may be manufactured using standard fin-based processes used for e.g. diodes, varactors, FinFETs or other types of semiconductor structures. Examples of such fabrication techniques include standard micro/nano-fabrication techniques, including deposition techniques such as atomic layer deposition, sputtering, pulsed laser deposition, chemical vapour deposition, etc. The fins may be formed of e.g. silicon, germanium, or any other semiconductor material. Several fins may be used, having a width and a spacing that advantageously is similar for all fins.

Since the fins may be cut into several separate fins, the term "fin" as referred to herein may in its broadest meaning be interpreted as a "fin track" or line, i.e., a design track or feature indicating the layout or position in which one fin, or several separate, consecutive fins, may be arranged.

According to an embodiment, the fin-shaped feature may have a uniform height in relation to the surface of the substrate, which may facilitate the forming and processing of the fin. Advantageously, standard processes for manufacturing fin-shaped features having a uniform height may be combined with the benefits of fin-shaped features having different protruding heights.

According to an embodiment, the fin-shaped feature may further comprise a gate stack arranged to contact the protruding part of the fin-shaped feature. The gate stack may be arranged to at least partly cover one or both of the sidewalls of the fin, and, preferably, also the top surface of the fin. The extension of the gate stack may define the channel region of the transistor device, with the source and drain regions of the transistor device arranged at the sides of the gate stack (as seen in the length direction of the fin). Preferably, a first gate stack may be arranged at the first protruding portion and a second gate stack arranged at the second protruding portion, thereby allowing two transistor devices of different channel width to be formed on the same fin.

The gate stack may comprise a gate dielectric that is formed on the top surface and the sidewalls of the fin, and a gate electrode that is formed over the gate dielectric.

It will be appreciated that the gate stack may be arranged on only one of the surfaces, such as one of the sidewall, on both of the sidewalls but not on the top surface, or on all three of the surfaces.

According to an embodiment, the semiconductor structure may comprise a first fin-shaped feature and a second fin-shaped feature, parallel to the first fin-shaped feature. The parallel fins may be aligned with each other in an alongside orientation, or shifted such that only a portion of each fin is arranged abreast of the other. Both of the fins may have a similar configuration, such as a similar height in relation to the surface of the substrate, similar length, width and/or protrusion from the isolating feature, or differ from each other in any of these parameters. Thus, the fins may in some examples have different heights from the surface of the substrate, differ in width, and/or configuration of the protruding portions. The fins may e.g. be matched to each other at the top of the fins, but differ from each other as measured down to the surface of the substrate (or isolating feature). The semiconductor structure may further comprise a first gate stack arranged to contact the first portion of the first fin-shaped feature and the first portion of the second fin-shaped feature. Thus, the semiconductor structure and the pair of fin-shaped features may form a first pair of transistor devices having a common gate stack defining the channel region of each transistor device, with the source and drain regions of the transistor devices arranged at the sides of the gate stack (as seen in the length direction of each fin).

According to an embodiment, the first portion of the first fin-shaped feature may protrude more from the isolating feature than the second portion of first fin-shaped feature. In other words, the first height may be greater than the second height. The second fin may be configured in a similar manner, i.e., such that the first portion of the second fin-shaped feature protrudes more from the isolating feature than the second portion of the second fin-shaped feature (or, in the above terminology: the first height may be greater than the second height). Alternatively, the first height of the second fin-shaped feature may be smaller than the second height of said fin-shaped feature. In yet an example, the first and second portions of the second fin may have similar or equal height.

According to an embodiment, the semiconductor structure may further comprise a second gate stack arranged to contact a second portion of the second fin-shaped feature and a second portion of the second fin-shaped feature, thereby forming a second pair of transistor devices for which the second gate stack is a common gate stack.

At least one of the first and second fin-shaped features may have a first and second protruding portion, wherein the height of the first portion (also referred to as a first height) may differ from the height of the second portion (also referred to as a second height). Thus, at least one of the first and second fins may comprise transistors of different channel width.

According to a second aspect, the semiconductor structure according to the first aspect and the associated embodiments may form a static random access memory, SRAM, device. The SRAM device may comprise a substrate, a plurality of fin-shaped features, of which at least some may be similar to those described in connection with the above embodiments, and one or several gate stacks.

In one example, the SRAM device may comprise at least four parallel fin-shaped features, i.e., a first, second, third and fourth fin-shaped feature, and a first and a second gate stack. The fins may be arranged next to each other in a consecutive order, such that the second fin is arranged next to the first fin, the third fin next to the second fin, and the fourth fin next to the third fin. The first gate stack may be arranged to contact a first portion of the first fin and a first portion of the second fin to define two transistors that may be connected to form a first inverter structure of the SRAM bit cell. Similarly, the second gate stack may be arranged to contact a second portion of the third fin and a second portion of the fourth fin to define two additional transistors, which may be connected to form a second inverter structure of the SRAM bit cell. These inverters, formed of a pair of a p-type (pull-down) transistor an n-type (pull-up) transistor, may thus form the VDD/VSS and common drain connections of the SRAM cell. Further, the SRAM device ay comprise a third gate stack arranged to contact a second portion of the first fin-shaped feature to define a fifth transistor structure, and a fourth gate stack arranged to contact a first portion of the fourth fin-shaped feature to define a sixth transistor structure. The fifth and sixth transistor devices may form the access transistors of the SRAM cell. Each of the six transistor structures may be similarly configured as the transistor structures described in connection with previous embodiments, wherein the extension of the gate stack may define the channel region of the transistor device, with the source and drain regions of the transistor device arranged at the sides of the gate stack (as seen in the length direction of the fin).

According to the present embodiment, at least the first fin-shaped feature and the fourth fin-shaped feature (i.e., the outer fin-shaped features of the set of four fin-shaped features) may be configured such that they both comprises two different protruding portions of different height, such that transistors of different channel width can be formed on each fin. The protruding portions of the first and fourth fin-shaped features may e.g. have two different heights, such that either one of the first and second portion of each fin has a height corresponding to the first height or the second height. The second and third fins may be formed with different protruding portions as well, or provided with protruding portions of uniform height. Thus, a number of different height combinations are available. One such example of combinations includes the case wherein the protruding portions of the outer fins (i.e., the first and fourth fin) have the first and second height, and both of the inner fins (i.e., the second and third fin) have one of the first and second heights, a first portion and second portion, respectively, of equal height. Thus, in the present example, the number of available heights of the protruding portions of all four fins may be limited to only two.

In an embodiment, the first portion of the first fin may protrude more, from the isolating feature, than the second portion of the first fin and the first portion of the second fin. Further, the second portion of the fourth fin may protrude more than the first portion of the fourth fin and the second portion of the third fin.

In an embodiment, the first portion of the first fin and the first portion of the second fin may protrude more than the second portion of the first fin. Further, the second portion of the third fin and the second portion of the fourth fin may protrude more than the first portion of the fourth fin.

In an embodiment, the first portion of the first fin and the first portion of the second fin may protrude more than the second portion of the first fin. Further, the second portion of the third fin feature and the first portion of the fourth fin feature may protrude less than the second portion of the fourth fin.

In an embodiment, the first portion of the first fin may protrude more than the first portion of the second fin feature and the second portion of the first fin. Further, the second portion of the third fin and the second portion of the fourth fin may protrude more than the first portion of the fourth fin.

According to an embodiment, the output of the first inverter may be connected to the input of the second inverter and vice versa. Thus, the first gate stack may be further arranged to contact the drain of the third transistor structure, i.e., the transistor formed at the crossing of the second gate stack and the third fin-shaped feature. Accordingly, the second gate stack may be arranged to contact the drain of the second transistor structure, i.e., the transistor formed at the crossing of the first gate stack and the second fin-shaped feature. In this way, the gate stacks may be used for cross connecting the first and second inverter forming the SRAM memory bit cell.

The present inventive concept is advantageous in that the channel width of the transistor devices of the SRAM cell may be adjusted such that the performance of the pull-up and pull-down transistors is balanced. Thus, if the pull-down transistor is a p-type transistor, which tend to have a lower drive current, a greater channel width may be employed to compensate for the lower hole mobility compared to the higher electron mobility of the n-type transistor forming the pull-up transistor.

According to a third aspect, a method for forming a semiconductor structure according to the first aspect is provided. The method may comprise forming at least one fin-shaped feature on the substrate, wherein the fin-shaped feature has a length in a direction extending along the substrate and a height in a direction extending from a surface of the substrate, and forming an isolating feature on the substrate such that a first portion of the fin-shaped feature protrudes with a first height from the isolating feature and a second portion protrudes with a second height from the isolating feature.

According to some embodiments, the fin-shaped feature may be formed by a selective deposition of material on the substrate, a selective removal or recessing of material, or both. The fin-shaped feature may e.g. be formed by and filling trenches into the substrate, wherein the height of the protruding portions may be determined by a selective deposition or recessing of the filling material of the trenches. Examples of techniques used for removing material include e.g. ion beam etching, wet etching, and dry etching.

It is noted that the present inventive concept relates to all possible combinations of features recited in the claims. Further, it will be appreciated that the various embodiments described for the semiconductor structure according to the first aspect are all combinable with embodiments described for the SRAM device according to the second aspect and the method according to the third aspect. Further objectives of, features of, and advantages with the present inventive concept will become apparent when studying the following detailed disclosure, the drawings, and the appended claims. Those skilled in the art will realise that different features of the present invention can be combined to create embodiments other than those described in the following

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figures 1a-b are perspective views of a semiconductor structure comprising a fin-shaped feature, an isolating feature and two gate stacks.
Figure 2 is a cross section of a semiconductor structure, taken across three parallel fin-shaped features having different protruding height.
Figures 3a-3d are schematic top views of semiconductor structures comprising two parallel fin-shaped features connected by one or two gate stacks.
Figures 4a-4d are schematic illustrations of the layout of SRAM cells, illustrating four parallel fin-shaped features and four gate stacks in different exemplary arrangements.
Figure 5 illustrates a circuit layout of an SRAM bit cell.
Figure 6 is a schematic illustration of the layout of two standard cells comprising a semiconductor structure according to the present inventive concept.

As illustrated in the figures, the sizes of the elements, features and other structures may be exaggerated or not depicted proportionally for illustrative purposes. Further, it is understood that other features and elements may be omitted or merely indicated for the ease of readability. Thus, the figures are provided to illustrate the general elements of the embodiments.

In the drawings, like reference numerals will be used for like elements unless stated otherwise.

### Detailed description

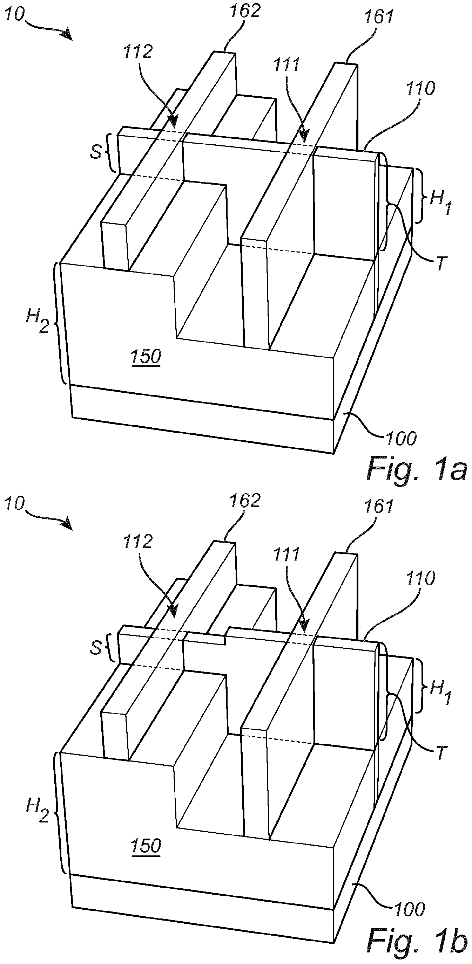

Figure 1a illustrates a semiconductor structure 10 according to an embodiment of the inventive concept, comprising a substrate 100, a fin-shaped feature 110 and an isolating feature 150. The substrate 100 may e.g. be formed of silicon, such as bulk silicon or silicon-on-isolation wafer, supporting the fin-shaped feature 110.

The fin-shaped feature 110, which also may be referred to as "fin", may e.g. be formed by etching trenches into the substrate 100, wherein the orientation and configuration of the trenches define the shape and position of the fin 110. Thus, the fin 110 may be formed of, or at least comprise, the same material as the substrate 100. Alternatively, or additionally the fin 110 may be formed by adding material to the substrate 100 in e.g. an epitaxial growth process or other material deposition methods known to a person skilled in the art. The fin 110 may have an elongated shape in a direction extending along the substrate 100 and a height in a direction extending from a surface of the substrate 100. Although not illustrated in the present example, the fin 110 may be cut into a plurality of fins arranged along the original extension or "track" defined by the fin 110. Thus, the term "fin" may refer to one or several fin portions arranged along the same track or line.

The isolating feature 150, or isolation, may be arranged at the lateral side of the fin 110, or, in case of several fins, between the fins. Thus, the isolating feature 150 may be arranged to at least partly cover the surface of the substrate 100 at positions not occupied by any fin. The isolating feature 150 may e.g. be arranged in the trenches defining the fin 110, and e.g. form a trench isolation or shallow trench isolation, STI. The isolation may e.g. comprise silicon oxide, or other suitable materials known in the art. As indicated in the present figure, the isolation 150 may be arranged at the lateral sides of the fin 110 such that the upper portions of the fin 110 may protrude from the surface of the isolation 150. In other words, the protruding upper portion(s) of the fin 110 are not isolated by the isolating feature 150 and may therefore be subjected to further processing steps. In the example embodiment illustrated in figure 1a, the fin 110 comprises two different portions that protrude from the isolating feature 150: a first portion 111, having a first height T (as measured from the surface of the isolating feature), and a second portion 112, having a second height S. The size of the protruding portions 111, 112, i.e., the first and second heights T, S may be determined by the thickness of the isolating feature 150 arranged at those portions 111, 112. As shown in figure 1a, the isolating feature 150 may be relatively thin, with a first thickness H₁, at the first portion 111 and relatively thick, with a second thickness H₂, at the second portion 112 of the fin 110. Given a fin 110 of uniform height, this results in a larger protruding fin height at the first portion 111 than at the second portion 112.

The different height, or thickness H₁, H₂ of the isolating feature 150 may e.g. be achieved by recessing (e.g. by etching) the isolating feature at the first portion 111, while leaving a thicker isolation at the second portion 112. Alternatively, or additionally, material may be selectively added to the isolation at the second portion 112 of the fin, resulting in a locally thicker isolation.

In some examples, the isolating feature may have a thickness H₁, H₂ that varies between 1/3 and 2/3 of the total fin height, such as e.g. 40 and 60 nm for a total fin height of 120 nm. In other words, the protruding portion may, in the same examples, vary from 80 nm (tall) to 60 nm (short).

The semiconductor structure 10 may further comprise a gate stack arranged to contact a protruding part of the fin, thereby providing a gate by which the operation of a transistor, formed of the fin, may be controlled. In the example illustrated in figure 1a, the semiconductor structure 10 comprises two gate stacks, a first one 161 arranged to contact the first protruding portion 111, and a second one 162 arranged to contact the second protruding portion 112. The gate stack may be arranged at both sidewalls and the top surface of the fin, as illustrated in the present example, or at only one or two of said surfaces. The gate width, or channel length, of the transistor formed at the first portion 111 and the second portion 112, may be determined by the height H₁, H₂ of the respective sidewalls and the width of the fin 110. Thus, the first protruding portion 111 of the fin 110 may result in a transistor having a greater channel width, and hence drive current, compared to the transistor formed at the second, lower protruding portion 112 of the fin 110. This allows, e.g., the performance of the both transistors to be balanced.

Figure 1b illustrate a semiconductor structure 10 according to an embodiment of the inventive concept, which may be similarly configured as the embodiment described with reference to figure 1a. The semiconductor structure 10 of figure 1b however differs from the one of figure 1a in that the fin 110 has a non-uniform upper portion, i.e., a height (as measured from the surface of the substrate 100) that varies along the length of the fin 110. This may e.g. be achieved by means of a selective removal of material from the fin 110. In the present example, the total height of the fin 110 may be reduced at the second portion 112, which may result in reduced second height S as compared to the corresponding portion illustrated in the example of figure 1a.

It will however be appreciated that the embodiments illustrated in figures 1a and 1b merely are examples of possible configurations of the fin 110. Other combinations and variations of the fin height, the thickness H₁, H₂ of the isolating feature 150 and the resulting heights S, T of the protruding portions 111, 112 are also conceivable. Different heights S, T of the protruding portions 111, 112 may for example be achieved by using a uniform isolating features, i.e., for which the thicknesses H₁, H₂ are equal along the fin 110, and wherein the height of the fin 110 is varied instead. The varying height may e.g. be provided during the formation of the fin, in which the different portions 111, 112 of the fin 110 e.g. may be selectively grown, or by a subsequent etch of the portions 111, 112 of the fin. The varying height of the fin 110 may also be provided by a selective removal of material from the substrate 100. Alternatively, or additionally, the thickness H₁, H₂ of the isolating feature may be varied by a selective deposition of material or a selective removal of material at the lateral sides of the fin 110.

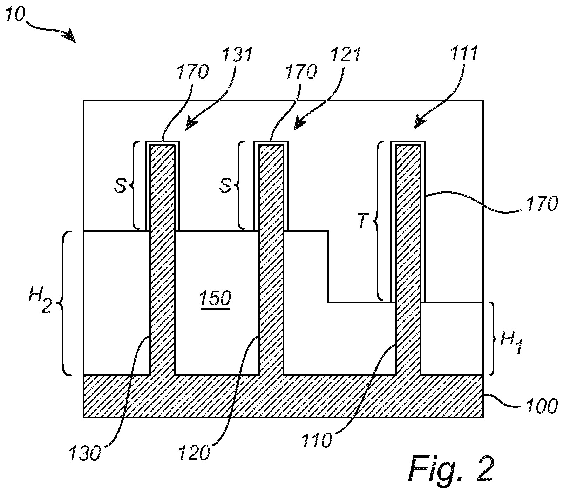

Figure 2 is a cross section of a semiconductor structure 10 according to an embodiment, which may be similarly configured as the structure 10 discussed above in connection with figures 1a and 1b. Thus, the structure 10 comprises a substrate 100, an isolating feature 150 and a gate stack 161 (comprising a gate oxide 170 and a gate contact) similar to what is described above. The present example however differs in that the structure 10 comprises three parallel fins 110, 120, 130, across which the cross section is taken. At the particular position along the length of the fins 110, 120, 130 shown in the cross section, the isolating feature 150 may be relatively thin (also referred to as a shallow STI, having a thickness H₁) at the first fin 110 and relatively thick (also referred to as a deep STI, having a thickness H₂) at the second and third fin 120, 130. Hence, the protruding portion 111 of the first fin 110 may be larger than the protruding portions 121, 131 of the second and third fins 120, 130. As shown in figure 2, the protruding portion 111 of the first fin 110 may be referred to as a "tall" portion T, whereas the corresponding portions 121, 131 of the second and third fins 120, 130 may be referred to as "short" portions S. It will be understood that the thickness of the isolating feature 150 also may vary along each fin 110, 120, 130 even if this is not shown in the cross section of figure 2.

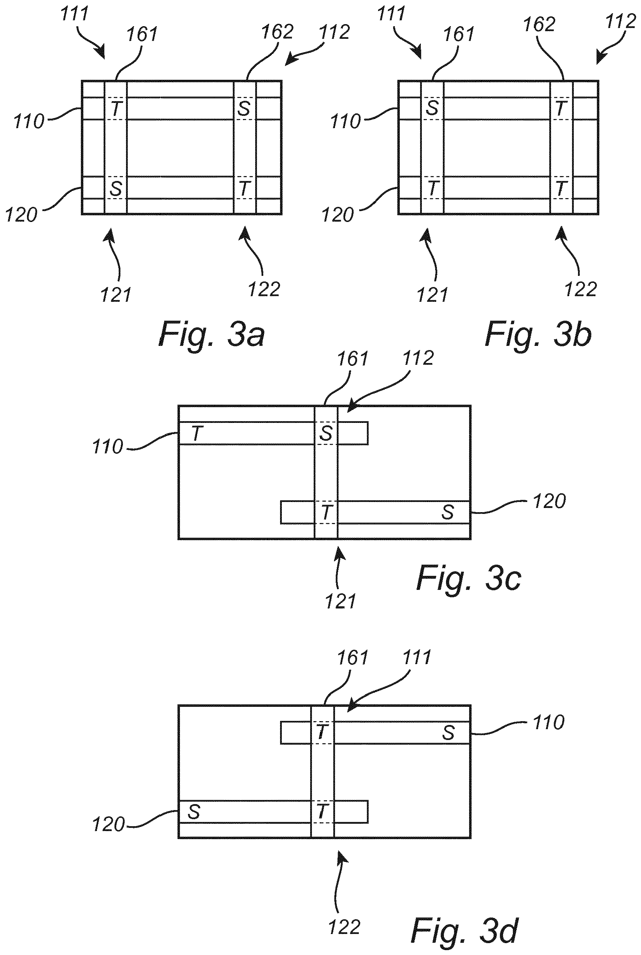

Figures 3a-3d are schematic top views of semiconductor structures two fin-shaped features 110, 120 arranged in parallel pairs. The fins 110, 120 may be similarly configured as in the embodiments discussed in connection with figures 1 and 2. Hence, each fin 110, 120 may comprise at least two portions 111, 112; 121, 122 protruding with at least a first height T or a second height S from the surface of the isolating feature. As discussed above, the first height T may be greater than the second height S.

The layouts shown in figures 3a-3d illustrate different example combinations of transistors, such as e.g. FinFETs, having a relatively large channel width (corresponding to a fin portion with height T) and a relatively small channel width (corresponding to a fin portion with height S), respectively. The transistors at the T portions of the fins 110, 120 may e.g. be p-type transistors, whereas the transistors at the S portions of the fins 110, 120 may be n-type transistors in order to compensate for the mobility differences between the p-type and n-type transistors.

Figure 3a is an example wherein the first portion 111 of the first fin 110 is a T portion and the second portion 112 of the first fin 110 is an S portion, whereas the first portion 121 of the second fin 120 is an S portion and the second portion 122 of the second fin 120 is a T portion. Both fins 110, 120 are aligned side by side, and connected by a first gate stack 161 and a second gate stack 161 which may run orthogonal to the fins 110, 120. The first gate stack 161 may be arranged to contact the T portion 111 of the first fin 110 and the S portion 121 of the second fin, and the second gate stack 162 to contact the S portion 112 of the first fin 110 and the T portion 122 of the second 122 fin. Hence, each of the fins in figure 3a may comprise two different transistors, i.e., transistors having different channel width, and each of the transistors of one fin may form a pair with a transistor of another fin.

Figure 3b illustrates another combination of S/T portions of a transistor layout, which may be similar to the embodiment of figure 3a. In this example, the first fin 110 has a first portion 111 of height S and a second portion 112 of height T, whereas the second fin 120 may have a uniform height T. Thus, the first gate stack 161 may form a S/T transistor pair and the second gate stack 161 a T/T transistor pair. Other combinations are however conceivable, wherein the first/second portions 121, 122 of the second fin 120 e.g. may have S/S or T/S heights.

In figures 3a and 3b the first and second fins 110, 120 are aligned with each other such that their respective first and second portions are abreast of each other. The present inventive concept is however not limited so such configurations. The fins 110, 120 may e.g. be shifted in relation to each other, such as illustrated in the following figures.

Figures 3c and 3d show a similar layout, in which the second portion 112 of the first fin 110 is aligned with the first portion 121 of the second fin 120. Thus, the first gate stack 161 may be arranged to contact the second portion 112 of the first fin 110 and the first portion 121 of the second fin 120, thereby forming a transistor pair that are connected by the gate stack 161. Various combinations of T/S portions may be provided, as illustrated in figures 3c and 3d. The first fin 110 may e.g. have a first portion 111 of height T and a second portion of height S, or vice versa. This fin may then be combined with a second fin 120 having a first portion 121 of height T and a second portion 122 of height S, a first portion 121 of height S and a second portion 122 of height T, or having a uniform shape of height T or S. The specific height combinations may be selected depending on the desired performance and the application the transistors are going to be used in.

The semiconductor structure according to the above embodiments, in which the same fin may be used to form transistors of different channel width, may e.g. be used in memory cells, such as e.g. SRAM cell. In the following, an illustrating example of a 6T SRAM cell will be described to illustrate advantages and possible applications of the semiconductor structure.

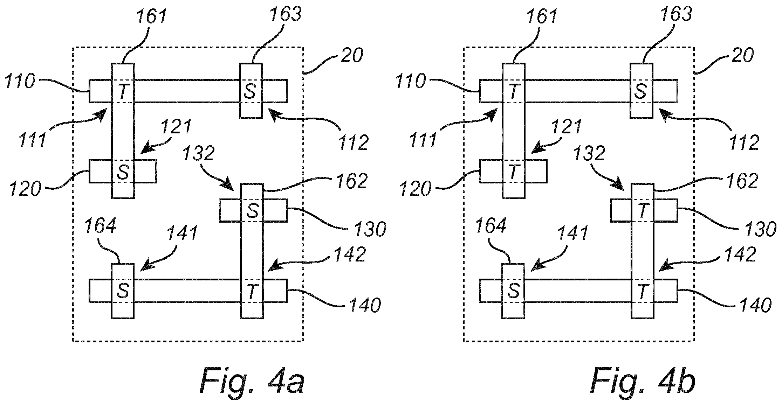

Figures 4a to 4d show an SRAM cell layout, wherein four fin-shaped features similar to the ones of the above embodiments may be arranged in parallel and connected by gate stacks to form and connect the transistors of the SRAM cell.

The first and second fin 110, 120 may be arranged in a first pair, and the third and fourth fin 130, 140 in a second pair. The first gate stack 161 may be arranged to form a first transistor with the first fin 110 and a second transistor with the second fin 120, and the second gate stack 162 arranged to form a third transistor with the third fin 130 and a fourth transistor with the fourth fin 140. Further, a third gate stack 163 and a fourth gate stack 164 may be arranged to form a fifth transistor and a sixth transistor with the first fin 110 and the fourth fin 140, respectively. The first fin and the third fin 110, 130 may have a length allowing at least two transistors to be formed on each fin, wherein the second and fourth fin 120, 140 may be cut into a reduced length (as compared to the first and third fins 110, 130), accommodating one transistor. In the examples shown in figures 4a to 4d, the first fin 110 has a first portion 111 of the first height T and as second portion 112 of the second height S. This is however merely an example; other configurations are possible, such as e.g. a first portion 111 of the second height S and a second portion 112 of the first height T.

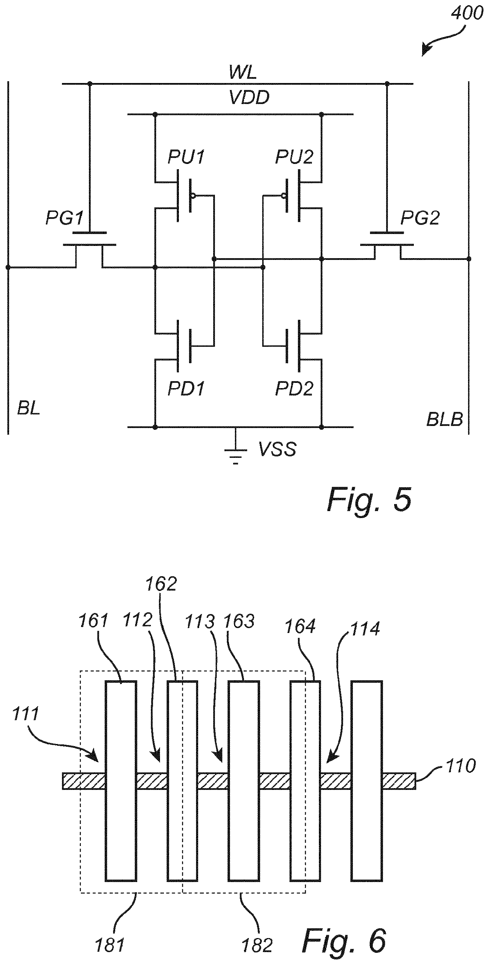

Figure 4a shows an example, wherein the T transistor of the first fin 110 may be a p-type transistor, acting as a first pull-down transistor PD1 of the bit cell, and the S transistor may be an n-type transistor acting as the first pass-gate transistor PG1 of the SRAM device (please refer to figure 5 for a detailed description of a corresponding circuit layout of an SRAM bit cell). The fourth fin 140 may have a similar configuration, in which the second portion 142 may have the second first length T and define a p-type transistor acting as a second pull-down transistor PD2 of the memory bit cell, and wherein the first portion 141 may have the second length S and define an n-type transistor acting as the second pass-gate transistor PG2 of the SRAM device. The second and third fin 120, 130 may both have a similar configuration, such as e.g. S/S (or T/T as shown in figure 4b), defining transistors acting as e.g. the first pull-up transistor PU1 and the second pull-up transistor PU2, respectively, of the SRAM device. The first pull-up transistor PU1 and the first pull-down transistor PD2 may thus form a first inverter, whereas the second pull-up transistor PU2 and the second pull-down transistor PD2 form a second inverter. These inverters may then be cross coupled, e.g. by the first and second gate stacks 161, 162, into the memory bit cell storing the logic "1" or "0" of the SRAM device as known in the art.

The SRAM device of e.g. figure 4a thus benefits from the possibility to form transistors of different fin height on the same fin, since the performance of the pull-down transistors PD1, PD2 (arranged at the first portion 111 of the first fin 110 and the second portion 142 of the fourth fin 140) may be adjusted or balanced to the performance of the pass-gate transistors PG1, PG2 (arranged at the second portion 112 of the first fin 110 and the first portion 141 of the fourth fin 140). The height of the portions forming the pull-down transistors PD1, PD2 may e.g. be adjusted by recessing the STI at those portions. Further, the varying height of the fin portions also allows for the pull-down transistors PD1, PD2 to be matched or balanced against the pull-up transistors PU1, PU2 of the bit cell.

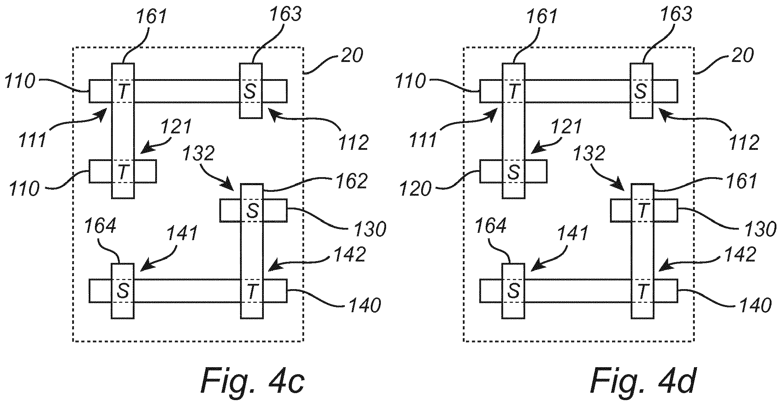

Figures 4c and 4d show other examples of possible height combinations, in which the first pull-up transistor PU1 and the second pull-up transistor PU2 may be formed at a fin portion of the first height T or the second height S.

Figure 5 illustrates the corresponding circuit layout of an SRAM bit cell as discussed e.g. in connection with the embodiment of figure 4 above. In figure 5, PU1 and PD1 denote first pull-up and pull-down transistors, PU2 and PD2 denote second pull-up and pull-down transistors, and PG1 and PG2 denote first and second pass transistors PG1, PG2. As shown, the pull-up transistor PU1 and the pull-down transistor PD1 are connected to form a first inverter. The pull-up transistor PU2 and the pull-down transistor PD2 are connected to form a second inverter. The first and the second inverters may furthermore be cross-coupled to each other and hence form a cross-coupled inverter pair.

Figure 6 is a schematic layout of a first and a second standard cell 181, 182 comprising a semiconductor structure according to an embodiment of the present inventive concept. The semiconductor structure forming the present example may be similarly configured as the semiconductor structure according to the previous embodiments. In the present example, the semiconductor structure may comprise at least one fin 110 and a plurality of gate stacks 161, 162, 163, 164, 165, preferably arranged in a transversal grid structure over the fin, forming the desired transistor structures. The first standard cell 181 may comprise a first portion 111 of the fin 110 and a first gate stack 161, and the second standard cell 181 a third portion 113 of the fin 110 and a third gate stack 163. Further, both cells 181, 182 may share a common dummy structure, in the present example indicated as a second gate stack 162, arranged between the first and third stacks 161, 163. Advantageously, the dummy structure 162 may be used as a break between two adjoining cells 181, 182 of different channel width, wherein the first portion 111 of the fin 110 e.g. may be of a first (tall) height T and the third portion 113 of a second (short) height T. The second portion 112 may e.g. be of the first (tall) height T and shared by the edges of the adjacent cells 181, 182.

Thus, as illustrated in the example of figure 6, the semiconductor structure according to the present inventive concept may be used to form standard cells comprising transistor devices of channels widths that may vary between the standard cells. Further, the standard cells may be separated by dummy features, such as e.g. the above described dummy gate stack structures, which e.g. may be overlap with the edges of the neighbouring cells. The separating dummy features may be provided with protruding portion of the fin having the same height as the protruding portion of one of the standard cells, or a different, third height.

The terms first, second and the like in the description are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

In the above the inventive concept has mainly been described with reference to a limited number of examples. However, as is readily appreciated by a person skilled in the art, other examples than the ones disclosed above are equally possible within the scope of the inventive concept, as defined by the appended claims. The inventive concept is for example not limited to fins wherein the protruding portions have only two different heights. On the contrary, a fin may be provided with protruding portions having a third or fourth or even more heights that all may differ from each other. Further, it is understood that the concept is not necessarily limited to embodiments wherein all fins have the same height, length or orientation. The same fin may have several different heights, and two fins may differ in height relative to each other.

## Claims

1. A semiconductor structure (10) comprising:
a substrate (100); and
at least one fin-shaped feature (110) arranged on the substrate, the fin-shaped feature having a length in a direction extending along the substrate and a height in a direction extending from a surface of the substrate; wherein
a first portion (111) of the fin-shaped feature protrudes with a first height (T) from an isolating feature (150) arranged on the substrate; and
a second portion (112) of the fin-shaped feature protrudes with a second height (S) from the isolating feature.

2. The semiconductor structure according to claim 1, wherein the fin-shaped feature has a uniform height in relation to the surface of the substrate.

3. The semiconductor structure according to claim 1 or 2, wherein each one of the first and second portion comprises a gate stack (161, 162) arranged to contact the protruding part of the fin-shaped feature to define a channel region;
the semiconductor structure device further comprising:
a source region; and
a drain region;
wherein the channel region is arranged between the source region and the drain region.

4. The semiconductor structure according to claim 1 or 2, comprising:
a first fin-shaped feature (110);
a second fin-shaped feature (120), being parallel with the first fin-shaped feature; and
a first gate stack (161) arranged to contact a first portion (111) of the first fin-shaped feature and a first portion (121) of the second fin-shaped feature.

5. The semiconductor structure according to claim 4, wherein:
the first portion (111) of the first fin-shaped feature (110) protrudes more from the isolating feature than a second portion (112) of the first fin-shaped feature; and/or
the first portion (121) of the second fin-shaped feature (120) protrudes at least one of less than, more than, or equal to a second portion (122) of the second fin-shaped feature.

6. The semiconductor structure according to claim 5, further comprising a second gate stack (161) arranged to contact a second portion (112) of the first fin-shaped feature and a second portion (122) of the second fin-shaped feature.

7. A static random access memory, SRAM, device (20) comprising:
a substrate (100);
at least four parallel fin-shaped features (110, 120, 130, 140) according to claim 1 or 2, arranged such that the second fin-shaped feature is arranged next to the first fin-shaped feature, the third fin-shaped feature is arranged next to the second fin-shaped feature, and the fourth fin-shaped feature is arranged next to the third fin-shaped feature;
a first gate stack (161) arranged to contact a first portion (111) of the first fin-shaped feature (110) and a first portion (121) of the second fin-shaped feature (120) to define a first transistor structure (PD1) and a second transistor structure (PU1), respectively, that are further connected to form a first inverter;
a second gate stack (162) arranged to contact a second portion (132) of the third fin-shaped feature (130) and a second portion (142) of the fourth fin-shaped feature (140) to define a third transistor structure (PU2) and a fourth transistor structure (PD2), respectively, that are further connected to form a second inverter;
a third gate stack (163) arranged to contact a second portion (112) of the first fin-shaped feature to define a fifth transistor structure (PG1), and;
a fourth gate stack (164) arranged to contact a first portion (141) of the fourth fin-shaped feature to define a sixth transistor structure (PG2).

8. The SRAM device according to claim 7, wherein:
the first portion (111) of the first fin-shaped feature (110) protrudes more, from the isolating feature, than the second portion (112) of the first fin-shaped feature and the first portion (121) of the second fin-shaped feature (120); and
the second portion (142) of the fourth fin-shaped feature (140) protrudes more, from the isolating feature, than the first portion (141) of the fourth fin-shaped feature (140) and the second portion (132) of the third fin-shaped feature (130).

9. The SRAM device according to claim 7, wherein:
the first portion (111) of the first fin-shaped feature (110) and the first portion (121) of the second fin-shaped feature (120) protrude more, from the isolating feature, than the second portion (112) of the first fin-shaped feature; and
the second portion (132) of the third fin-shaped feature (130) and the second portion (142) of the fourth fin-shaped feature (140) protrude more, from the isolating feature, than the first portion (141) of the fourth fin-shaped feature.

10. The SRAM device according to claim 7, wherein:
the first portion (111) of the first fin-shaped feature (110) and the first portion (121) of the second fin-shaped feature (120) protrude more, from the isolating feature, than the second portion (112) of the first fin-shaped feature; and
the second portion (132) of the third fin-shaped feature (130) and the first portion (141) of the fourth fin-shaped feature (140) protrude less, from the isolating feature, than the second portion (142) of the fourth fin-shaped feature.

11. The SRAM device according to claim 7, wherein:
the first portion (111) of the first fin-shaped feature (110) protrudes more, from the isolating feature, than the first portion (121) of the second fin-shaped feature (120) and a second portion (112) of the first fin-shaped feature; and
the second portion (132) of the third fin-shaped feature (130) and the second portion (142) of the fourth fin-shaped feature (140) protrude more, from the isolating feature, than the first portion (141) of the fourth fin-shaped feature (140).

12. The semiconductor structure according to any one of claims 8 to 11, wherein the first gate stack is further arranged to contact the drain of the third transistor structure, and wherein the second gate stack is further arranged to contact the drain of the second transistor.

13. A method for forming a semiconductor structure on a substrate, comprising:
forming at least one fin-shaped feature on the substrate, wherein the fin-shaped feature has a length in a direction extending along the substrate and a height in a direction extending from a surface of the substrate; and
forming an isolating feature on the substrate; wherein:
a first portion of the fin-shaped feature protrudes with a first height from the isolating feature; and
a second portion of the fin-shaped feature protrudes with a second height from the isolating feature.

14. The method according to claim 13, wherein the fin-shaped feature is formed by a selective deposition of material on the substrate or a selective removal of material from the substrate.

15. The method according to claim 13 or 14, wherein the isolating feature is formed by a selective deposition of material or a selective removal of material at the lateral sides of the fin-shaped feature.
